# EUROPEAN PATENT SPECIFICATION

(11) **EP 4 152 484 B1**
(45) Date of publication and mention of the grant of the patent: **25.02.2026**
(21) Application number: 20936668.1
(22) Date of filing: 18.05.2020
(51) Int. Cl.: H01M 50/10, H01M 10/42

(54) **BATTERY BOX BODY, BATTERY SET, AND BATTERY BOX**
BATTERIEKASTENKÖRPER, BATTERIESATZ UND BATTERIEKASTEN
CORPS DE COFFRE DE BATTERIE, ENSEMBLE BATTERIE ET COFFRE DE BATTERIE

(43) Date of publication of application: 22.03.2023
(73) Proprietor: NINGDE AMPEREX TECHNOLOGY LIMITED, Ningde City, Fujian Province 352100 (CN)
(72) Inventor: HU, Lianya, Dongguan City, Guangdong Province, 523000 (CN)
(74) Representative: Icosa
(86) International application number: PCT/CN2020/090899
(87) International publication number: WO 2021/232205

(56) References cited:
- CN-A- 107 154 470
- CN-A- 110 800 129
- CN-U- 201 540 927
- CN-Y- 201 238 056
- DE-A1- 102014 200 983
- DE-A1- 102016 203 553
- US-A1- 2014 193 694
- US-B2- 10 615 394
- US-B2- 9 385 355

## Description

### TECHNICAL FIELD

This application relates to the technical field of batteries, and in particular, to a battery box body, a battery pack, and a battery box.

### BACKGROUND

An electric vehicle is generally powered by electrical energy provided by a battery pack, so as to be driven to move. The battery pack generally includes a battery box body and a cell module accommodated in the battery box body. The battery box body serves main functions of supporting, fixing, and protecting the cell module, and needs to be of high mechanical strength, high electrical performance, high thermal performance, and high troubleshooting capabilities. Generally, all such factors are criteria for determining whether the battery pack is good or not. The battery box body in the prior art is complicated in structure, and is not satisfactory enough in thermal performance. Typical examples of battery box bodies in the prior art are disclosed by US 2014/193694 A1 and DE 10 2016 203553 A1.

### SUMMARY

In view of the foregoing, it is necessary to provide a battery box body, a battery pack, and a battery box to simplify the structure and provide high heat-dissipation performance.

A battery box body is disclosed, including a housing, provided with an accommodation cavity, the housing comprises a second sidewall and a fourth sidewall, the second sidewall is opposite to the fourth sidewall; a partition plate, disposed in the accommodation cavity, and configured to partition the accommodation cavity into a plurality of space blocks, where each space block is configured to receive a cell module; a fixing bracket, detachably disposed on the housing, and configured to fix a battery management system and the cell module to the housing, where two opposite sides of the fixing bracket abut against the second sidewall and the fourth sidewall respectively; and a cover body, detachably disposed on the housing and configured to cap the accommodation cavity.

Optionally, a first guiding piece is disposed on the second sidewall and a second guiding piece is disposed on the fourth sidewall (104) respectively, and the fixing bracket is sandwiched between the two guiding pieces.

Optionally, a side of the second guiding piece opposite from the fourth sidewall tilts against a plane of the fourth sidewall, a side of the first guiding piece opposite from the second sidewall tilts against a plane of the second sidewall, and the first guiding piece and the second guiding piece are disposed parallel to each other.

Optionally, the fixing bracket is connected onto the partition plate and the housing by means of snap-fastening and/or bolting.

Optionally, a first mounting portion is disposed on the fourth sidewall, and the fixing bracket is fixed onto the first mounting portion by a bolt.

Optionally, the cover body is detachably disposed on the partition plate.

Optionally, the fixing bracket is provided with a slot. The partition plate is provided with a hook, and the hook engages in the slot.

Optionally, the housing comprises a first sidewall and a third sidewall, the first sidewall is opposite to the third sidewall, the partition plate includes a first end and a second end disposed opposite to each other, a gap is formed between the first end and the housing, and the second end is connected to a sidewall of the housing.

Optionally, the partition plate is provided with a notch near the second end. The notch is configured to receive a wire harness for connecting the battery management system and the cell module.

Optionally, both the partition plate and the housing are made of heat-dissipating materials.

Optionally, a heat sink is disposed on both an outer side of the housing and an outer side of the cover body.

According to the claimed invention, the cover body is provided with a pressing block. The pressing block presses on the fixing bracket, and a cushion is disposed between the pressing block and the fixing bracket.

According to the claimed invention, a pressure sensor is disposed on the cushion and is configured to sense pressure exerted by the cover body on the fixing bracket.

Optionally, a harness limiting structure is disposed on the fixing bracket, and is configured to limit a position of a wire harness in the battery box body.

Optionally, the harness limiting structure includes a limiting block disposed protrusively on the fixing bracket. A limiting hole is disposed on the limiting block. The limiting hole is configured to allow a wire harness to pass through the hole.

A battery pack is disclosed, including the foregoing battery box body, a cell module, and a battery management system. The cell module is accommodated in an accommodation cavity. A fixing bracket presses on the cell module. The battery management system is fixed on the fixing bracket and abuts against a cover body. Optionally, a radiator is disposed on the battery management system. The radiator is bonded to the cover body by a thermally conductive adhesive.

Optionally, a pot gel is disposed in the housing. The pot gel is configured to equalize a temperature of the cell module.

Optionally, a fixing structure is disposed on the fixing bracket, and is configured to limit a position of the battery management system.

Optionally, the fixing structure is a protruding post disposed protrusively on the fixing bracket.

Optionally, the protruding post is plural in number, and the plurality of protruding posts are disposed around the battery management system.

A battery box is disclosed, including the foregoing battery pack.

The battery box body is structurally simple and easy to assemble, and is of high mechanical strength and high heat-dissipation performance.

### BRIEF DESCRIPTION OF DRAWINGS

FIG. 1 is a schematic structural diagram of a battery box body according to an embodiment of the present application;
FIG. 2 is a schematic structural diagram of a housing of the battery box body shown in FIG. 1;
FIG. 3 is a schematic structural diagram of a housing of the battery box body shown in FIG. 1 from another viewing angle;
FIG. 4 is a schematic structural diagram of a housing of the battery box body shown in FIG. 1 from still another viewing angle;
FIG. 5 is a schematic structural diagram of a fixing bracket of the battery box body shown in FIG. 1;
FIG. 6 is a schematic structural diagram of coordination between a housing and a fixing bracket of the battery box body shown in FIG. 1;
FIG. 7 is a schematic structural diagram of a cover body of the battery box body shown in FIG. 1;
FIG. 8 is a schematic structural diagram of a cover body of the battery box body shown in FIG. 1 from another viewing angle;
FIG. 9 is a schematic structural diagram of a battery pack according to an embodiment of the present application;
FIG. 10 is a schematic structural diagram of a part of section plane of the battery pack shown in FIG. 9; and
FIG. 11 is a schematic structural diagram of a part of section plane of the battery pack shown in FIG. 9.

### Reference numerals:

Battery box body 1
Housing 10
Accommodation cavity 100
First sidewall 101
Second sidewall 102
Guiding structure 1020
Third sidewall 103
Fourth sidewall 104
Bottom plate 105
Partition plate 16
First end 161
Second end 162
Notch 163
Hook 164
Gap 160
First mounting portion 107
Third mounting portion 108
Guiding piece 109
Fixing bracket 12
First side 120
Second side 121
Second mounting portion 122
Slot 123
Fixing structure 124
Harness limiting structure 125
Cushion 13
Pressure sensor 130
Cover body 14
Fourth mounting portion 140
Pressing block 141
Second heat sink 142
Explosion-proof valve 143
Battery pack 1000
Cell module 2
Battery management system 3
Fixing via hole 30
Radiator 31
Thermally conductive adhesive 32

The present application is further described below with reference to specific some embodiments and the foregoing drawings.

### DETAILED DESCRIPTION OF EMBODIMENTS

The following clearly describes the technical solutions in some embodiments of the present application in full with reference to the accompanying drawings in some embodiments of the present application. Apparently, the described some embodiments are merely some of but not all of some embodiments of the present application.

Unless otherwise defined, all technical and scientific terms used herein have the same meanings as what is usually understood by a person skilled in the technical field of the present application. The terms used in the specification of the present application are merely intended for describing specific some embodiments but not intended for limiting the present application.

The terms "first" and "second" used below are merely intended for descriptive purposes but are not to be understood as indicating or implying relative importance or as implicitly specifying the number of technical features indicated. Therefore, a feature qualified by "first", "second" and the like may explicitly or implicitly include one such feature or a plurality of the features. In the description of this application, unless otherwise specified, "a plurality of" means two or more. The directional terms such as "upper", "lower", "left", and "right" are defined relative to the orientation in which a component is schematically placed in the drawings. Understandably, the directional terms are relative concepts that are used for relative description and clarification, and may vary accordingly depending on the orientation of the component in the drawings.

In this application, unless otherwise expressly specified and qualified, the term "connect" is understood in a broad sense. For example, a "connection" may be a fixed connection, a detachable connection, or an integrated whole, and may be a direct connection or an indirect connection implemented through an intermediary. The term "and/or" used herein includes any and all combinations of one or more related items preceding and following the term.

When some embodiments are described below in detail with reference to schematic diagrams, for ease of description, a drawing that renders a partial structure of a device is not partially enlarged to scale. The schematic diagrams are merely examples, and do not hereby limit the protection scope of the present application.

The battery box body and the battery pack according to some embodiments of this application are applicable to electronic devices, especially electric vehicles and the like.

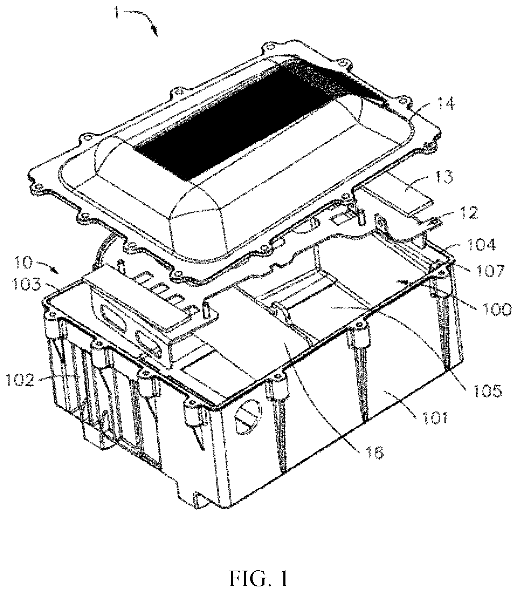

Refer to FIG. 1, which is a schematic structural diagram of a battery box body 1 according to an embodiment of the present application. The battery box body 1 includes a housing 10, a partition plate 16. a fixing bracket 12, and a cover body 14. The fixing bracket 12 is detachably disposed on the housing 10. The cover body 14 presses on the fixing bracket 12.

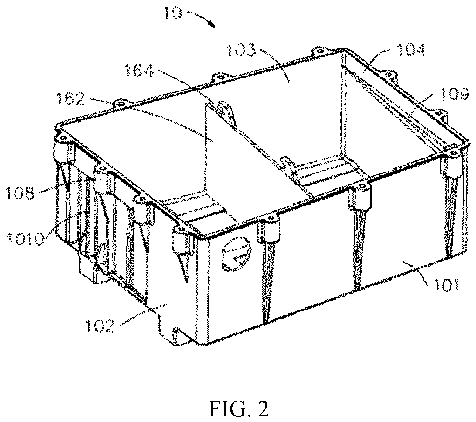

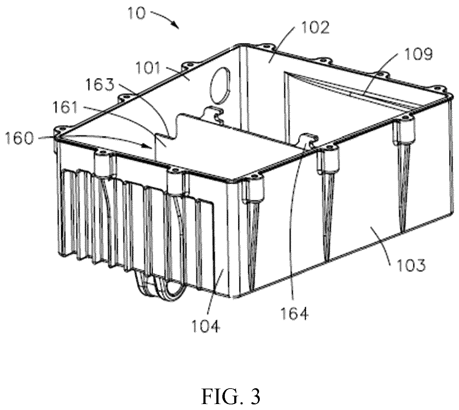

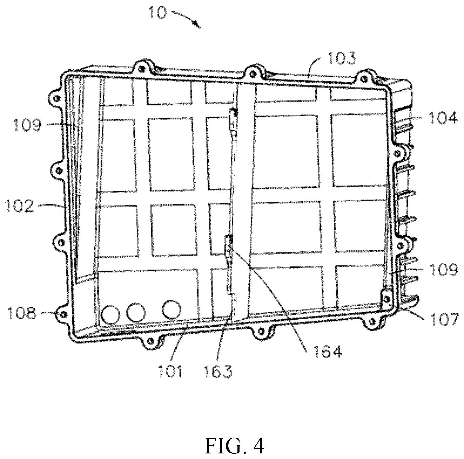

Referring to FIG. 2 to FIG. 4, the housing 10 is roughly rectangular and is provided with an accommodation cavity 100. The housing 10 includes a first sidewall 101, a second sidewall 102, a third sidewall 103, and a fourth sidewall 104, and a bottom plate 105 that is connected to the first sidewall 101, the second sidewall 102, and the first sidewall 103, and the fourth sidewall 104. The first sidewall 101, the second sidewall 102, the third sidewall 103, the fourth sidewall 104, and the bottom plate 105 close in to form the accommodation cavity 100. The accommodation cavity 100 is configured to accommodate the cell module. In some embodiments, the accommodation cavity 100 can accommodate two or more cell modules. The partition plate 16 is disposed in the accommodation cavity 100, and is configured to partition the accommodation cavity 100 into a plurality of space blocks. Each space block may be configured to receive a cell module. In an embodiment shown in the drawing, there is one partition plate 16 that partitions the accommodation cavity 100 into two space blocks. Understandably, the number of partition plates 16 may depend on the number of cell modules that need to be disposed. For example, if there are three cell modules, two partition plates 16 may be disposed for partitioning.

The partition plate 16 includes a first end 161 and a second end 162. The first end 161 is opposite to the second end 162, and the second end 162 abuts against the third sidewall 103 of the housing 10. A gap 160 is disposed between the first end 161 and the first sidewall 101. The first end 161 is also provided with a notch 163. The gap 160 and the notch 163 are configured to facilitate passage of a wire harness between the space blocks.

The housing 10 is provided with a first mounting portion 107. The first mounting portion 107 is configured to mount and fix the fixing bracket 12. In an embodiment shown in the drawing, the first mounting portion 107 is a positioning hole. The fixing bracket 12 coordinates with the positioning hole through a bolt, so that the fixing bracket 12 is fastened onto the housing 10.

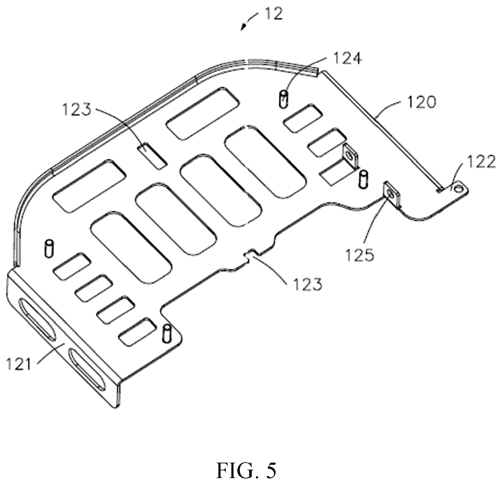

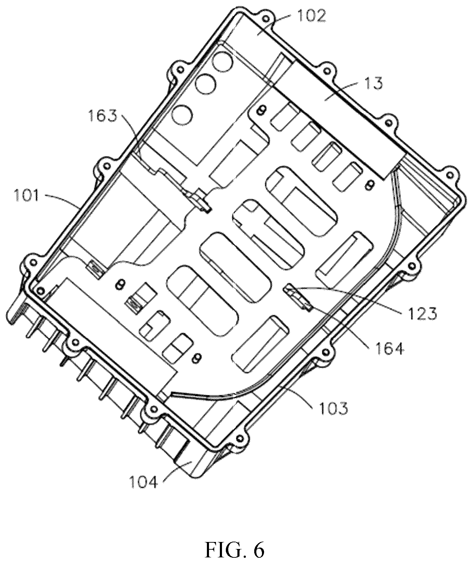

Referring to FIG. 5 and FIG. 6, the fixing bracket 12 is configured to fix a battery management system (Battery Management System, BMS) and a cell module. The fixing bracket 12 includes a first side 120 and a second side 121 that is opposite to the first side 120. The first side 120 abuts against on the fourth sidewall 104 of the housing 10, the second side 121 abuts against on the second sidewall 102 of the housing 10 . The fixing bracket 12 is provided with a second mounting portion 122 corresponding to the first mounting portion 107. The second mounting portion 122 is a via hole corresponding to the positioning hole. A bolt passes through the via hole and the positioning hole consecutively to fasten the fixing bracket 12 to the housing 10. Understandably, in other embodiments, the means of fastening between the fixing bracket 12 and the housing 10 is not limited to the positioning hole and the via hole shown in the drawing, but may be another similar fastening structure as long as the fastening structure can fasten the fixing bracket 12 onto the housing 10. For example, the fastening structure may be a buckle structure. Either the fixing bracket 12 or the housing 10 is provided with a slot, and the other is provided with a hook. The hook engages with the slot to serve a fastening function.

To further fix the fixing bracket 12, the fixing bracket 12 may also be fastened to the partition plate 16. In an embodiment shown in the drawing, the partition plate 16 is provided with a hook 164, and the fixing bracket 12 is provided with a slot 123 correspondingly. The hook 164 engages with the slot 123 to fasten the fixing bracket 12 to the partition plate 16. Understandably, in other embodiments, the means of fastening the fixing bracket 12 to the partition plate 16 is not limited to an embodiment shown in the drawing, but may be any other appropriate fastening means as long as the fastening means can fasten the fixing bracket 12 to the partition plate 16.

To make it convenient to assemble the fixing bracket 12 onto the housing 10, the housing 10 is provided with guiding pieces 109. The fixing bracket 12 is sandwiched between two guiding pieces 109. In an embodiment shown in the drawing, the guiding pieces 109 are guiding blocks disposed on the second sidewall 102 and the fourth sidewall 104. Each of the guiding blocks is a bevel structure. A side of the guiding block opposite from the second sidewall 102 or the fourth sidewall 104 tilts against a plane on which the second sidewall 102 or the fourth sidewall 104 is located. The guiding piece 109 disposed on the second sidewall 102 is approximately parallel to the guiding piece disposed on the fourth sidewall 104. Understandably, in other embodiments, the guiding piece 109 may be other structures as long as the structure facilitates mounting of the fixing bracket 12 onto the housing 10. For example, the first side 120 and the second side 121 of the fixing bracket 12 may be provided with guiding strips. The second sidewall 102 and the fourth sidewall 104 may be provided with guiding slots correspondingly. The guiding strips coordinate with the guiding slots so that the fixing bracket 12 is guided to be assembled onto the housing 10.

The fixing bracket 12 is configured to carry the battery management system. To make it convenient to limit the position of the battery management system module, the fixing bracket 12 is provided with a fixing structure 124 configured to limit the position of the battery management system when the battery management system is carried on the fixing bracket 12, so that the position of the battery management system remains unchanged relative to the fixing bracket 12. In an embodiment shown in the drawing, the fixing structure 124 is four protruding posts disposed protrusively on the fixing bracket 12 and configured to limit horizontal displacement and vertical displacement of the battery management system respectively. Understandably, in other embodiments, the limiting structure may be another structure that fits with the shape of the battery management system, such as a limiting slot, a limiting buckle, or the like.

In further some embodiments, the fixing bracket 12 is further provided with a harness limiting structure 125. The harness limiting structure 125 is configured to limit the position of a wire harness that passes through the structure. In an embodiment shown in the drawing, the harness limiting structure 125 is a limiting block that is disposed protrusively on a main body of the fixing bracket 12. The limiting block is provided with a limiting hole to allow the wire harness or a cable tie to pass through the limiting hole, thereby limiting the position of the wire harness or the cable tie.

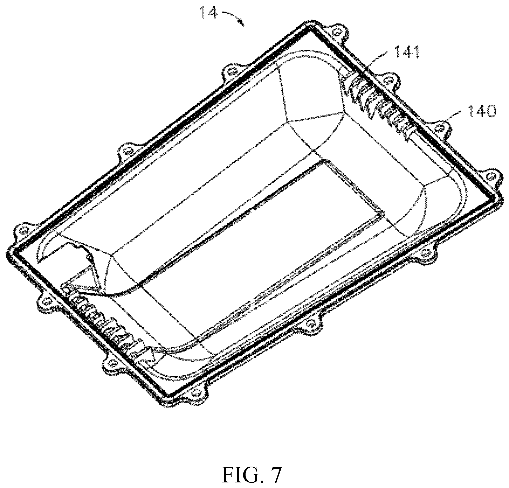

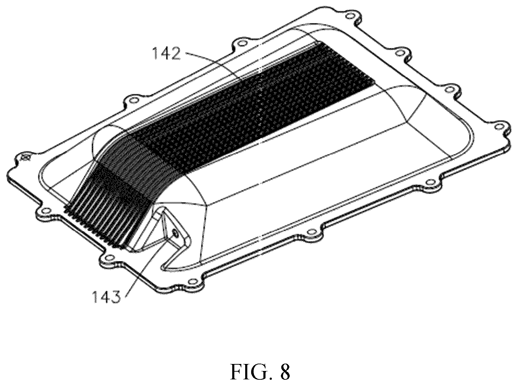

Referring to FIG. 7 and FIG. 8, the cover body 14 detachably presses on the housing 10 to cap the accommodation cavity 100. An accommodation space enclosed between the cover body 14 and the partition plate 16 is configured to allow for assembling of the battery management system. An accommodation space enclosed between the partition plate 16 and the housing 10 is configured to receive the cell module.

The housing 10 is provided with a third mounting portion 108. The cover body 14 is provided with a fourth mounting portion 140 correspondingly. The third mounting portion 108 coordinates with the fourth mounting portion 140 to fix the cover body 14 onto the housing 10. In an embodiment shown in the drawing, the third mounting portion 108 is a screw hole, and the fourth mounting portion is a via hole. The bolt passes through the via hole and the screw hole to fasten the cover body 14 to the housing 10. There are a plurality of screw holes, evenly distributed on the four sidewalls of the housing 10. Understandably, in other embodiments, the means of fastening the housing 10 to the cover body 14 is not limited to some embodiment shown in the drawing, but may be any other appropriate fastening structure as long as the fastening structure can fasten the cover body 14 to the housing 10. For example, the fourth mounting portion 140 is a screw hole, and the housing 10 is a via hole.

The cover body 14 is provided with a pressing block 141. The pressing block 141 presses on the fixing bracket 12, so that the fixing bracket 12 is further fastened between the cover body 14 and the housing 10. In some embodiment shown in the drawing, the pressing block 141 is disposed at two opposite sides of the cover body 14 separately and includes a plurality of pressing plates that are spaced apart. Understandably, in other embodiments, the shape of the pressing block 141 is not limited to some embodiment shown in the drawing. For example, there may be an integrated pressing block or several pressing blocks spaced apart, and the shape of the pressing block may be any appropriate geometric shapes such as a square or trapezoid.

According to the claimed invention, a cushion 13 is disposed between the pressing block 141 and the fixing bracket 12. The cushion 13 is configured to buffer the pressure exerted by the cover body 14 on the fixing bracket 12. In some embodiments, the cushion 13 is a flexible rubber pad. Understandably, in other embodiments, the cushion 13 may be any material serving a function of buffering, such as sponge, silicone, and the like.

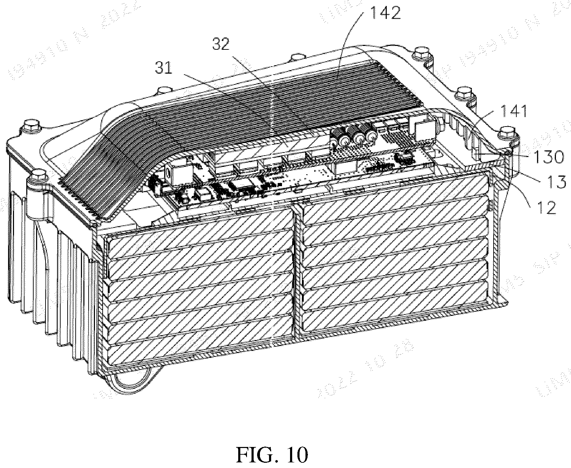

According to the claimed invention, a pressure sensor 130 (shown in FIG. 10) is disposed on the cushion 13. The pressure sensor 130 is configured to sense pressure exerted by the cover body 14 on the fixing bracket 12. The pressure sensor 130 can provide warning support when the pressure exceeds a preset value.

To facilitate dissipation of heat in the battery box body 1, both the partition plate 16 and the housing 10 are made of heat-dissipating materials. To further improve the heat dissipation effect, a heat sink is disposed on both an outer side of the housing 10 and an outer side of the cover body 14. As shown in FIG. 2, a first heat sink 1010 is disposed on the second sidewall 102. As shown in FIG. 8, the second heat sink 142 is disposed at the top of the cover body 14.

The cover body 14 is further provided with an explosion-proof valve 143. The explosion-proof valve 143 is configured to relieve the pressure when a gas pressure in the battery box body 1 reaches a preset value, so as to prevent the battery box body 1 from exploding due to excessive gas pressure in the box body.

In assembling the battery box body 1, the fixing bracket 12 is fixed in coordination with the partition plate 16 first, so that the slot 123 of the fixing bracket 12 engages firmly with the hook 164 on the partition plate 16. Then a bolt passes through the second mounting portion 122 on the fixing bracket 12 and the first mounting portion 107 on the housing 10 to fasten the fixing bracket 12 to the housing 10. Then the housing 10 is capped with the cover body 14 so that the pressing block 141 abuts against the cushion 13. A bolt passes through the fourth mounting portion 140 on the cover body 14 and the third mounting portion 108 on the housing 10 to fasten the cover body 14 to the housing 10.

The battery box body 1 according to an embodiment of the present application is structurally simple and easy to assemble, and is of high heat-dissipation performance. The cover body 14 abuts against the fixing bracket 12 through the pressing block 141 and the cushion 13, so that the fixing bracket 12 is fastened between the cover body 14 and the housing 10 to prevent shaking up and down.

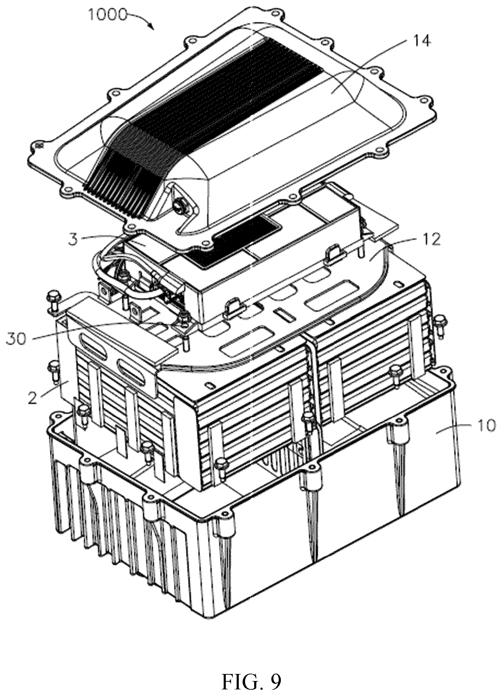

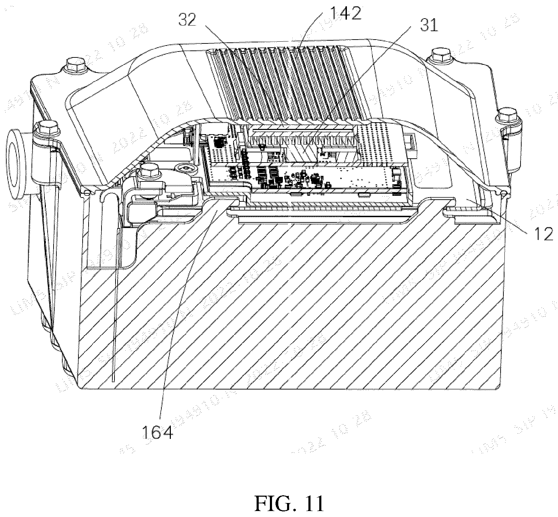

Refer to FIG. 8 to FIG. 11, which are schematic structural diagrams of a battery pack 1000 according to an embodiment of the present application.

The battery pack 1000 includes the battery box body 1 according to the foregoing some embodiment, and a cell module 2 and a battery management system 3 that are disposed in the battery box body 1. The cell module 2 is disposed in the accommodation cavity 100. The fixing bracket 12 presses on the cell module 2. Four sidewalls of the housing 10 abut against outer sidewalls of the cell module 2 respectively to limit the displacement of the cell module 2 along an X axis (horizontal direction) and a Y axis (vertical direction). The fixing bracket 12 presses on the cell module 2 to limit the displacement of the cell module 2 along a Z axis.

The battery management system 3 is disposed on the fixing bracket 12 and abuts against the cover body 14. The battery management system 3 is provided with a fixing via hole 30. The position of the fixing via hole 30 corresponds to the position of the fixing structure 124 on the fixing bracket 12. The fixing structure 124 passes through the fixing via hole 30, thereby limiting the displacement of the battery management system 3 along the X axis (horizontal direction) and the Y axis (vertical direction). An inner sidewall of the cover body 14 abuts against the battery management system 3 to limit the displacement of the battery management system 3 along the Z axis.

A radiator 31 is disposed on the battery management system 3. The radiator 31 is bonded to the cover body 14 by a thermally conductive adhesive 32. In this way, heat generated by an electronic component in the battery management system 3 is dissipated by the radiator 31 and the thermally conductive adhesive 32, and by a second heat sink 142 on the cover body 14. Heat generated by the cell module 2 is dissipated by first heat sinks 1010 at two sides of the housing 10 and by the partition plate 16.

In further some embodiments, to enhance the heat dissipation effect, a pot gel may be disposed in the housing 10 to equalize and relieve the temperature of the cell module 2.

The heat generated by the electronic component in the battery management system 3 is separated from the heat generated by the cell module 2. The two types of heat are dissipated by the second heat sink 142 on the cover body 14 and the first heat sink 1010 on the housing 10 respectively, thereby effectively enhancing the heat dissipation efficiency.

The battery pack 1000 uses the battery box body to fix the battery management system 3 and the cell module 2 to achieve high structural stability, high mechanical capability, and high heat-dissipation efficiency.

In some embodiments of the present application, a battery box is further provided. Two or more battery packs 1000 described above are disposed in the battery box, so as to combine a plurality of battery packs.

The foregoing descriptions are merely specific implementations of this application, but are not intended to limit the protection scope of this application. Any variations or replacements made within the technical scope disclosed herein fall within the protection scope of this application. Therefore, the protection scope of this application shall be subject to the protection scope of the claims.

## Claims

1. A battery box body (1), wherein the battery box body (1) comprising:
a housing (10) provided with an accommodation cavity (100), the housing comprises, a second sidewall (102) and a fourth sidewall (104), the second sidewall (102) is opposite to the fourth sidewall (104);
a partition plate (16) disposed in the accommodation cavity (100), and configured to partition the accommodation cavity (100) into a plurality of space blocks, wherein each space block is configured to receive a cell module (2);
a fixing bracket (12) detachably disposed on the housing (10), and configured to fix a battery management system (3) and the cell module (2) to the housing (10), wherein two opposite sides of the fixing bracket (12) abut against the second sidewall (102) and the fourth sidewall (104) respectively;
a cover body (14) detachably disposed on the housing (10) and configured to cap the accommodation cavity (100);
wherein the cover body (14) is provided with a pressing block (141), the pressing block (141) presses on the fixing bracket (12), and a cushion (13) is disposed between the pressing block (141) and the fixing bracket (12);
a pressure sensor (130) is disposed on the cushion (13) and is configured to sense pressure exerted by the cover body (14) on the fixing bracket (12).

2. The battery box body (1) according to claim 1, wherein a first guiding piece (109) is disposed on the second sidewall (102) and a second guiding piece (109) is disposed on the fourth sidewall (104) respectively, and the fixing bracket (12) is sandwiched between the two guiding pieces (109).

3. The battery box body (1) according to claim 2, wherein a side of the second guiding piece (109) opposite from the fourth sidewall (104) tilts against a plane of the fourth sidewall (104), a side of the first guiding piece (109) opposite from the second sidewall (102) tilts against a plane of the second sidewall (102); and the first guiding piece and the second guiding piece (109) are disposed parallel to each other.

4. The battery box body (1) according to claim 1, wherein the fixing bracket (12) is connected onto the partition plate (16) and the housing (10) by means of snap-fastening and/or bolting.

5. The battery box body (1) according to claim 4, wherein a first mounting portion (107) is disposed on the fourth sidewall (104), and the fixing bracket (12) is fixed onto the first mounting portion (107) by a bolt.

6. The battery box body (1) according to claim 1, wherein the cover body (14) is detachably disposed on the partition plate (16).

7. The battery box body (1) according to claim 6, wherein the fixing bracket (12) is provided with a slot (123), the partition plate (16) is provided with a hook (164), and the hook (164) engages in the slot (123).

8. The battery box body (1) according to any one of claims 1 to 6, wherein the housing comprises a first sidewall (101) and a third sidewall (103), the first sidewall (101) is opposite to the third sidewall (103);
the partition plate (16) comprises a first end (161) and a second end (162) disposed opposite to each other, a gap (160) is formed between the first end (161) and the first sidewall (101), and the second end (162) is connected to the third sidewall (103).

9. The battery box body (1) according to claim 8, wherein the partition plate (16) is provided with a notch (163) near the second end (162), and the notch (163) is configured to receive a wire harness for connecting the battery management system (3) and the cell module (2).

10. The battery box body (1) according to claim 8, wherein a harness limiting structure (125) is disposed on the fixing bracket (12), is configured to limit a position of a wire harness in the battery box body (1), and includes a limiting block disposed protrusively on the fixing bracket.

11. A battery pack, comprising the battery box body (1) according to any one of claims 1 to 10, a cell module (2), and a battery management system (3); wherein the cell module (2) is accommodated in an accommodation cavity (100), a fixing bracket (12) presses on the cell module (2), and the battery management system (3) is fixed on the fixing bracket (12) and abuts against a cover body (14).

12. The battery pack according to claim 11, wherein a fixing structure (124) is disposed on the fixing bracket (12), and is configured to limit a position of the battery management system (3).

13. A battery box, wherein the battery box comprising the battery pack according to any one of claims 11 to 12.

## Patentansprüche

1. Batteriekastenkörper (1), wobei der Batteriekastenkörper (1) umfasst:
ein Gehäuse (10), das mit einem Unterbringungshohlraum (100) bereitgestellt ist, wobei das Gehäuse eine zweite Seitenwand (102) und eine vierte Seitenwand (104) umfasst, die zweite Seitenwand (102) der vierten Seitenwand (104) gegenüberliegt;
eine Trennplatte (16), die in dem Unterbringungshohlraum (100) angeordnet, und konfiguriert ist, um den Unterbringungshohlraum (100) in eine Vielzahl von Raumblöcken zu unterteilen, wobei jeder Raumblock konfiguriert ist, um ein Zellmodul (2) aufzunehmen;
eine Befestigungshalterung (12), die lösbar an dem Gehäuse (10) angeordnet, konfiguriert ist, um ein Batteriemanagementsystem (3) und das Zellmodul (2) an dem Gehäuse (10) zu befestigen, wobei zwei gegenüberliegende Seiten der Befestigungshalterung (12) jeweils an der zweiten Seitenwand (102) und der vierten Seitenwand (104) anliegen;
einen Abdeckkörper (14), der lösbar an dem Gehäuse (10) angeordnet, und konfiguriert ist, um den Unterbringungshohlraum (100) zu deckeln;
wobei der Abdeckkörper (14) mit einem Pressblock (141) bereitgestellt ist, der Pressblock (141) auf die Befestigungshalterung (12) presst, und ein Kissen (13) zwischen dem Pressblock (141) und der Befestigungshalterung (12) angeordnet ist;
wobei ein Drucksensor (130) auf dem Kissen (13) angeordnet, und konfiguriert ist, um den durch den Abdeckkörper (14) auf die Befestigungshalterung (12) ausgeübten Druck zu messen.

2. Batteriekastenkörper (1) nach Anspruch 1, wobei jeweils ein erstes Führungsstück (109) an der zweiten Seitenwand (102) angeordnet ist, und ein zweites Führungsstück (109) an der vierten Seitenwand (104) angeordnet ist und die Befestigungshalterung (12) zwischen den beiden Führungsstücken (109) eingefügt ist.

3. Batteriekastenkörper (1) nach Anspruch 2, wobei eine der vierten Seitenwand (104) gegenüberliegende Seite des zweiten Führungsstücks (109) zu einer Ebene der vierten Seitenwand (104) geneigt ist, eine der zweiten Seitenwand (102) gegenüberliegende Seite des ersten Führungsstücks (109) zu einer Ebene der zweiten Seitenwand (102) geneigt ist; und das erste Führungsstück und das zweite Führungsstück (109) parallel zueinander angeordnet sind.

4. Batteriekastenkörper (1) nach Anspruch 1, wobei die Befestigungshalterung (12) mittels Schnappbefestigung und/oder Verschraubung mit der Trennplatte (16) und dem Gehäuse (10) verbunden ist.

5. Batteriekastenkörper (1) nach Anspruch 4, wobei ein erster Montageabschnitt (107) an der vierten Seitenwand (104) angeordnet ist und die Befestigungshalterung (12) mit einer Schraube an dem ersten Montageabschnitt (107) befestigt ist.

6. Batteriekastenkörper (1) nach Anspruch 1, wobei der Abdeckkörper (14) lösbar an der Trennplatte (16) angeordnet ist.

7. Batteriekastenkörper (1) nach Anspruch 6, wobei die Befestigungshalterung (12) mit einem Schlitz (123) bereitgestellt ist, die Trennplatte (16) mit einem Haken (164) bereitgestellt ist und der Haken (164) in den Schlitz (123) eingreift.

8. Batteriekastenkörper (1) nach einem der Ansprüche 1 bis 6, wobei das Gehäuse eine erste Seitenwand (101) und eine dritte Seitenwand (103) umfasst, wobei die erste Seitenwand (101) der dritten Seitenwand (103) gegenüberliegt;
wobei die Trennplatte (16) ein erstes Ende (161) und ein zweites Ende (162) umfasst, die einander gegenüberliegend angeordnet sind, ein Spalt (160) zwischen dem ersten Ende (161) und der ersten Seitenwand (101) gebildet ist und das zweite Ende (162) mit der dritten Seitenwand (103) verbunden ist.

9. Batteriekastenkörper (1) nach Anspruch 8, wobei die Trennplatte (16) mit einer Kerbe (163) in der Nähe des zweiten Endes (162) bereitgestellt ist und die Kerbe (163) konfiguriert ist, um einen Kabelbaum zu der Verbindung des Batteriemanagementsystems (3) und des Zellmoduls (2) aufzunehmen.

10. Der Batteriekastenkörper (1) nach Anspruch 8, wobei eine Kabelbaumbegrenzungsstruktur (125) an der Befestigungshalterung (12) angeordnet ist, die konfiguriert ist, um eine Position eines Kabelbaums in dem Batteriekastenkörper (1) zu begrenzen, und einen Begrenzungsblock beinhaltet, der hervorstehend an der Befestigungshalterung angeordnet ist.

11. Batteriepack, umfassend den Batteriekastenkörper (1) nach einem der Ansprüche 1 bis 10, ein Zellmodul (2) und ein Batteriemanagementsystem (3); wobei das Zellmodul (2) in einem Unterbringungshohlraum (100) untergebracht ist, eine Befestigungshalterung (12) auf das Zellmodul (2) presst, und das Batteriemanagementsystem (3) an der Befestigungshalterung (12) befestigt ist und an einem Abdeckkörper (14) anliegt.

12. Batteriepack nach Anspruch 11, wobei eine Befestigungsstruktur (124) an der Befestigungshalterung (12) angeordnet, und konfiguriert ist, um eine Position des Batteriemanagementsystems (3) zu begrenzen.

13. Batteriekasten, wobei der Batteriekasten den Batteriepack nach einem der Ansprüche 11 bis 12 umfasst.

## Revendications

1. Un boîtier de batterie (1), dans lequel le boîtier de batterie (1) comprend :
un logement (10) muni d'une cavité de réception (100), le logement (10) comprenant une deuxième paroi latérale (102) et une quatrième paroi latérale (104), la deuxième paroi latérale (102) étant opposée à la quatrième paroi latérale (104) ;
une plaque de séparation (16) disposée dans la cavité de réception (100) et configurée pour diviser la cavité de réception (100) en plusieurs blocs d'espace, chaque bloc d'espace étant conçu pour recevoir un module de cellule (2) ;
une équerre de fixation (12) disposée de manière amovible sur le logement (10) et configurée pour fixer un système de gestion de batterie (3) et le module de cellule (2) au logement (10), deux côtés opposés de l'équerre de fixation (12) étant en appui contre la deuxième paroi latérale (102) et la quatrième paroi latérale (104) respectivement ;
un couvercle (14) disposé de manière amovible sur le logement (10) et configuré pour fermer la cavité de réception (100) ;
le couvercle (14) étant muni d'un bloc de pression (141), le bloc de pression (141) exerçant une pression sur l'équerre de fixation (12), et un coussin (13) étant disposé entre le bloc de pression (141) et l'équerre de fixation (12) ;
un capteur de pression (130) étant disposé sur le coussin (13) et configuré pour détecter la pression exercée par le couvercle (14) sur l'équerre de fixation (12).

2. Le boîtier de batterie (1) selon la revendication 1, dans lequel une première pièce de guidage (109) est disposée sur la deuxième paroi latérale (102) et une deuxième pièce de guidage (109) est disposée sur la quatrième paroi latérale (104), et l'équerre de fixation (12) est serrée entre les deux pièces de guidage (109).

3. Le boîtier de batterie (1) selon la revendication 2, dans lequel un côté de la deuxième pièce de guidage (109) opposé à la quatrième paroi latérale (104) est incliné par rapport au plan de la quatrième paroi latérale (104), un côté de la première pièce de guidage (109) opposé à la deuxième paroi latérale (102) est incliné par rapport au plan de la deuxième paroi latérale (102) ; et la première pièce de guidage et la deuxième pièce de guidage (109) sont disposées parallèlement l'une à l'autre.

4. Le boîtier de batterie (1) selon la revendication 1, dans lequel l'équerre de fixation (12) est fixée à la plaque de séparation (16) et au logement (10) par encliquetage et/ou boulonnage.

5. Le boîtier de batterie (1) selon la revendication 4, dans lequel une première partie de montage (107) est disposée sur la quatrième paroi latérale (104), et l'équerre de fixation (12) est fixée à la première partie de montage (107) par un boulon.

6. Le boîtier de batterie (1) selon la revendication 1, dans lequel le couvercle (14) est disposé de manière amovible sur la plaque de séparation (16).

7. Le boîtier de batterie (1) selon la revendication 6, dans lequel l'équerre de fixation (12) est munie d'une fente (123), la plaque de séparation (16) est munie d'un crochet (164), et le crochet (164) s'engage dans la fente (123).

8. Le boîtier de batterie (1) selon l'une quelconque des revendications 1 à 6, dans lequel le logement comprend une première paroi latérale (101) et une troisième paroi latérale (103), la première paroi latérale (101) étant opposée à la troisième paroi latérale (103) ;
la plaque de séparation (16) comprend une première extrémité (161) et une deuxième extrémité (162) disposées en regard l'une de l'autre, un espace (160) étant formé entre la première extrémité (161) et la première paroi latérale (101), et la deuxième extrémité (162) étant reliée à la troisième paroi latérale (103).

9. Le boîtier de batterie (1) selon la revendication 8, dans lequel la plaque de séparation (16) est munie d'une encoche (163) près de la deuxième extrémité (162), et l'encoche (163) est configurée pour recevoir un faisceau de câbles destiné à connecter le système de gestion de batterie (3) et le module de cellule (2).

10. Le boîtier de batterie (1) selon la revendication 8, dans lequel une structure de limitation de faisceau (125) est disposée sur l'équerre de fixation (12), est configurée pour limiter la position d'un faisceau de câbles dans le boîtier de batterie (1), et comprend un bloc de limitation faisant saillie sur l'équerre de fixation.

11. Un bloc batterie, comprenant le boîtier de batterie (1) selon l'une quelconque des revendications 1 à 10, un module de cellule (2) et un système de gestion de batterie (3) ; dans lequel le module de cellule (2) est logé dans une cavité de réception (100), une équerre de fixation (12) exerce une pression sur le module de cellule (2), et le système de gestion de batterie (3) est fixé sur l'équerre de fixation (12) et est en appui contre un couvercle (14).

12. Le pack batterie selon la revendication 11, dans lequel une structure de fixation (124) est disposée sur l'équerre de fixation (12) et est configurée pour limiter la position du système de gestion de batterie (3).

13. Un boîtier de batterie, dans lequel le boîtier de batterie comprend le pack batterie selon l'une quelconque des revendications 11 à 12.
